# FASCICULE DE BREVET EUROPEEN

(11) **EP 3 764 547 B1**
(45) Date de publication et mention de la délivrance du brevet: **11.01.2023**
(21) Numéro de dépôt: 20182883.7
(22) Date de dépôt: 29.06.2020
(51) Int. Cl.: H03L 7/199, H03L 7/107

(54) **PROCÉDÉ DE GESTION DU DÉMARRAGE D'UNE BOUCLE À VERROUILLAGE DE PHASE, ET CIRCUIT INTÉGRÉ CORRESPONDANT**
VERFAHREN ZUR STEUERUNG DES STARTS EINER PHASENREGELSCHLEIFE, UND ENTSPRECHENDER INTEGRIERTER SCHALTKREIS
METHOD FOR MANAGING THE STARTING OF A PHASE LOCKING LOOP, AND CORRESPONDING INTEGRATED CIRCUIT

(30) Priorité: 09.07.2019 FR 1907661
(43) Date de publication de la demande: 13.01.2021
(73) Titulaire: STMicroelectronics (Rousset) SAS, 13790 Rousset (FR)
(72) Inventeur: GAILHARD, Bruno, 13840 Rognes (FR); TRUPHEMUS, Laurent, 83910 Pourrieres (FR); EVA, Christophe, 13790 Rousset (FR)
(74) Mandataire: Casalonga

(56) Documents cités:
- EP-A2- 1 170 869
- US-A- 5 898 328
- US-A1- 2002 153 959
- US-A1- 2008 036 513

## Description

Des modes de mise en œuvre et de réalisation de l'invention concernent les circuits intégrés, et notamment les boucles à verrouillage de phase, communément désignées par l'homme du métier sous le vocable anglosaxon de « Phase-locked loop », et plus particulièrement la gestion de leur démarrage.

Les boucles à verrouillage de phase sont généralement utilisées dans des systèmes numériques requérant une fréquence interne de travail importante, par exemple de l'ordre de plusieurs centaines de mégahertz.

Les boucles à verrouillage de phase ont donc notamment pour rôle de délivrer à ces systèmes numériques, par exemple un cœur programmable ou un microprocesseur, un signal d'horloge interne ayant une fréquence de travail importante.

La publication de brevet EP1170869A2 décrit un procédé de gestion du fonctionnement d'une boucle à verrouillage de phase (PLL) pour le verrouillage d'une boucle à verrouillage de phase lorsque le réglage de la fréquence de cette boucle change.

Cependant, en raison de la présence de la boucle de retour et du réseau capacitif nécessaires pour la stabilité de la boucle à verrouillage de phase, la durée de démarrage, c'est-à-dire la durée au bout de laquelle la boucle est stabilisée, avec le signal de référence et le signal de sortie de l'oscillateur proches d'une synchronisation mutuelle, peut être très long, typiquement supérieure à 100 µs.

Par ailleurs, durant cette phase de démarrage, il existe un pic de fréquence (« frequency overshoot ») sur le signal de sortie de l'oscillateur de la boucle, par rapport à sa valeur finale nominale. Et ce pic de fréquence peut atteindre jusqu'à 25% de la valeur finale nominale.

Un tel pic de fréquence au démarrage implique que le circuit numérique de la PLL supporte une telle fréquence. La vitesse de ce circuit doit donc être augmentée, ce qui induit notamment une augmentation des courants de fuite et/ou de consommation dynamique.

Il existe par conséquent un besoin de limiter la durée de démarrage d'une boucle à verrouillage de phase ainsi que l'amplitude de ce pic de fréquence.

Selon un aspect, il est proposé un procédé de gestion du fonctionnement d'une boucle à verrouillage de phase.

Le fonctionnement de la boucle à verrouillage de phase comprend une phase ou étape de démarrage comportant :
- une délivrance à un comparateur de phase de la boucle, d'un signal de référence ayant un rapport cyclique de 50%,
- une réinitialisation, à chaque front d'un premier type, par exemple à chaque front montant, du signal de référence, d'un premier diviseur du signal de sortie de l'oscillateur contrôlé en tension de la boucle,
- une délivrance par le comparateur de phase recevant le signal de référence et un signal de retour issu du premier diviseur, à chaque front d'un deuxième type, par exemple à chaque front descendant, du signal de référence, d'une impulsion de commande au cours de laquelle la tension de contrôle de l'oscillateur augmente.

La combinaison de ces caractéristiques, et notamment la fourniture d'un signal de référence ayant un rapport cyclique de 50%, et une réinitialisation du diviseur de la boucle à chaque front montant (par exemple) du signal de référence permet une diminution significative de la durée de démarrage de la boucle ainsi que du pic de fréquence (frequency overshoot).

Ainsi, à titre indicatif, pour une fréquence du signal de référence égale à 2, 4, 8 ou 16 MHz et une fréquence nominale du signal de sortie de l'oscillateur égale à 832 MHz, on obtient une durée de démarrage de l'ordre de la trentaine de microsecondes contre une durée de démarrage de 70 à plus de 100 microsecondes pour une boucle à verrouillage classique.

De même, on obtient un pic de fréquence (frequency overshoot) sur le signal de sortie de l'oscillateur de l'ordre de quelques pourcents, par exemple de l'ordre de 2%, contre jusqu'à 25% pour une boucle à verrouillage de phase classique.

Dans le cas où l'on est en présence d'un signal de référence initial n'ayant pas un rapport cyclique de 50%, alors la délivrance du signal de référence comprend avantageusement une division par deux de ce signal de référence initial de façon à obtenir le signal de référence ayant le rapport cyclique de 50% et, dans ce cas, le signal de retour est non pas le signal de sortie issu directement du premier diviseur de la boucle mais le signal de sortie du premier diviseur, divisé par deux.

Ceci permet d'utiliser n'importe quel signal de référence initial, quel que soit son rapport cyclique.

Alors qu'il serait possible que l'impulsion de commande délivrée par le comparateur de phase soit utilisée dans un circuit de pompe de charge, il est particulièrement avantageux au cours de la phase de démarrage, de « court-circuiter » ce circuit de pompe de charge, d'appliquer directement un courant de précharge dans un filtre résistif capacitif connecté à l'entrée de l'oscillateur.

En d'autres termes, selon un tel mode de mise en œuvre, au cours de la phase de démarrage, l'augmentation de la tension de contrôle de l'oscillateur comprend une application d'un courant de précharge dans un filtre résistif capacitif connecté à l'entrée de l'oscillateur.

Ceci contribue encore à diminuer la durée de démarrage de la boucle et de rendre cette durée de démarrage moins dépendante des contraintes de courant de la pompe de charge, contraintes liées à la stabilité de la boucle.

Selon un mode de mise en œuvre, le filtre résistif capacitif comprend :
- une première branche connectée entre ladite entrée de l'oscillateur et la masse et comportant un réseau résistif connecté en série avec un premier condensateur ayant une première valeur capacitive, ledit réseau résistif comportant une première résistance connectée entre ladite entrée de l'oscillateur et un nœud intermédiaire et ayant une première valeur résistive, et une deuxième résistance connectée entre le nœud intermédiaire et le premier condensateur et ayant une deuxième valeur résistive, et
- une deuxième branche connectée entre ladite entrée de l'oscillateur et la masse et comportant un deuxième condensateur ayant une deuxième valeur capacitive.

La première valeur capacitive est alors avantageusement égale à a fois la deuxième valeur capacitive tandis que la première valeur résistive est égale à a fois la deuxième valeur résistive.

On applique alors avantageusement le courant de précharge audit nœud intermédiaire.

On obtient une augmentation homogène des deux tensions capacitives aux bornes des deux capacités, donc une augmentation stable de la tension capacitive délivrée en entrée de l'oscillateur.

Selon un mode de mise en œuvre, la phase de démarrage se termine lorsque la durée de l'impulsion de commande est inférieure à quelques pourcents, par exemple 2%, du produit de la période du signal de sortie de l'oscillateur par le rapport de division du premier diviseur.

Selon un mode de mise en œuvre, lorsque la phase de démarrage est terminée, la sortie du comparateur de phase est connectée à un circuit de pompe de charge dont la sortie est connectée à l'entrée de l'oscillateur contrôlé en tension.

En d'autres termes, lorsque durant la phase de démarrage, le circuit de pompe de charge a été déconnecté et un courant de précharge a été appliqué au niveau du filtre résistif capacitif, on reconnecte cettefois-ci à l'issue de la phase de démarrage, le circuit de pompe de charge au comparateur de phase.

Bien entendu, si pendant la phase de démarrage on avait laissé le circuit de pompe de charge connecté au comparateur de phase, on ne modifie pas cette connexion à l'issue de la phase de démarrage.

Selon un mode de mise en œuvre, lorsque durant la phase de démarrage, on a divisé par deux le signal de référence initial ainsi que le signal de sortie du premier diviseur, on ne procède plus à ces divisions par deux lorsque la phase de démarrage est terminée.

En d'autres termes, lorsque la phase de démarrage est terminée, on délivre au comparateur de phase le signal de référence initial tandis que le signal de retour délivré au comparateur de phase est le signal de sortie du premier diviseur.

Par ailleurs, lorsque la phase de démarrage est terminée, on peut avantageusement effectuer une ultime réinitialisation du premier diviseur sur le premier front d'un premier type, par exemple le premier front montant, du signal de référence suivant la fin de la phase de démarrage.

Ceci permet de synchroniser le signal de référence et le signal de retour issu du premier diviseur.

Selon un autre aspect, il est proposé un circuit intégré, comprenant une boucle à verrouillage de phase comportant
- un comparateur de phase, un oscillateur contrôlé en tension, un premier diviseur connecté entre la sortie de l'oscillateur et une première entrée du comparateur de phase,
- des moyens de délivrance configurés pour délivrer sur une deuxième entrée du comparateur de phase, lors d'une phase de démarrage de la boucle, un signal de référence ayant un rapport cyclique de 50%,
- des moyens de réinitialisation configurés pour, lors de ladite phase de démarrage, effectuer à chaque front d'un premier type du signal de référence, une réinitialisation du premier diviseur,
- le comparateur de phase étant configuré pour, lors de ladite phase de démarrage, délivrer, à chaque front d'un deuxième type du signal de référence, une impulsion de commande, et
- des moyens de contrôle configurés pour augmenter la tension de contrôle de l'oscillateur au cours de ladite impulsion de commande.

Selon un mode de réalisation, les moyens de délivrance comportent
- une entrée pour recevoir un signal de référence initial,
- un diviseur par deux connecté à ladite entrée, et
- une sortie configurée pour délivrer en tant que signal de référence, le signal de référence initial divisé par deux, et
- le circuit intégré comprend en outre un autre diviseur par deux connecté entre la sortie du premier diviseur et la première entrée du comparateur de phase.

Selon un mode de réalisation, les moyens de contrôle comportent une source de courant activable lors de ladite impulsion et configurée pour appliquer, une fois activée, un courant de précharge dans un filtre résistif capacitif connecté en entrée de l'oscillateur.

Selon un mode de réalisation, le filtre résistif capacitif comprend
- une première branche connectée entre ladite entrée de l'oscillateur et la masse et comportant un réseau résistif connecté en série avec un premier condensateur ayant une première valeur capacitive, ledit réseau résistif comportant une première résistance connectée entre ladite entrée de l'oscillateur et un nœud intermédiaire et ayant une première valeur résistive et une deuxième résistance connectée entre le nœud intermédiaire et le premier condensateur et ayant une deuxième valeur résistive, et
- une deuxième branche connectée entre ladite entrée de l'oscillateur et la masse et comportant un deuxième condensateur ayant une deuxième valeur capacitive,
- la première valeur capacitive étant égale à a fois la deuxième valeur capacitive, et la première valeur résistive est égale à a fois la deuxième valeur résistive, et dans lequel la source de courant est connectée audit nœud intermédiaire.

Selon un mode de réalisation, le circuit intégré comprend en outre des moyens de détection configurés pour détecter la fin de la phase de démarrage.

Selon un mode de réalisation, les moyens de détection sont configurés pour détecter la durée de l'impulsion de commande et/ou la nature du signal impulsionnel délivré par le comparateur de phase.

Ainsi les moyens de détection peuvent être configurés pour délivrer un signal représentatif de la fin de la phase démarrage lorsque la durée de l'impulsion de commande est inférieure quelques pourcents du produit de la période du signal de sortie de l'oscillateur par le rapport de division du premier diviseur.

En variante, les moyens de détection peuvent être configurés pour délivrer un signal représentatif de la fin de la phase démarrage lorsqu'est détectée la première impulsion du signal impulsionnel délivré par le comparateur de phase, demandant une diminution de la tension de contrôle de l'oscillateur contrôlé en tension.

Selon un mode de réalisation, le circuit intégré est configuré pour, lorsque la phase de démarrage est terminée, connecter la sortie du comparateur de phase à un circuit de pompe de charge dont la sortie est connectée à l'entrée de l'oscillateur contrôlé en tension.

Selon un mode de réalisation, lorsque la phase de démarrage est terminée, les moyens de délivrance sont configurés pour délivrer au comparateur de phase le signal de référence initial, et le circuit intégré comporte des moyens de commande configurés pour désactiver ledit autre diviseur par deux, de façon que le signal de retour délivré au comparateur de phase soit le signal de sortie du premier diviseur.

Selon un mode de réalisation, les moyens de réinitialisation sont configurés pour, lorsque la phase de démarrage est terminée, effectuer une ultime réinitialisation du premier diviseur sur le premier front d'un premier type du signal de référence suivant la fin de la phase de démarrage.

D'autres avantages et caractéristiques de l'invention apparaîtront à l'examen de la description détaillée des modes de mise en œuvre et de réalisation de l'invention, nullement limitatifs, et des dessins annexés sur lesquels :
[Fig 1]
[Fig 2]

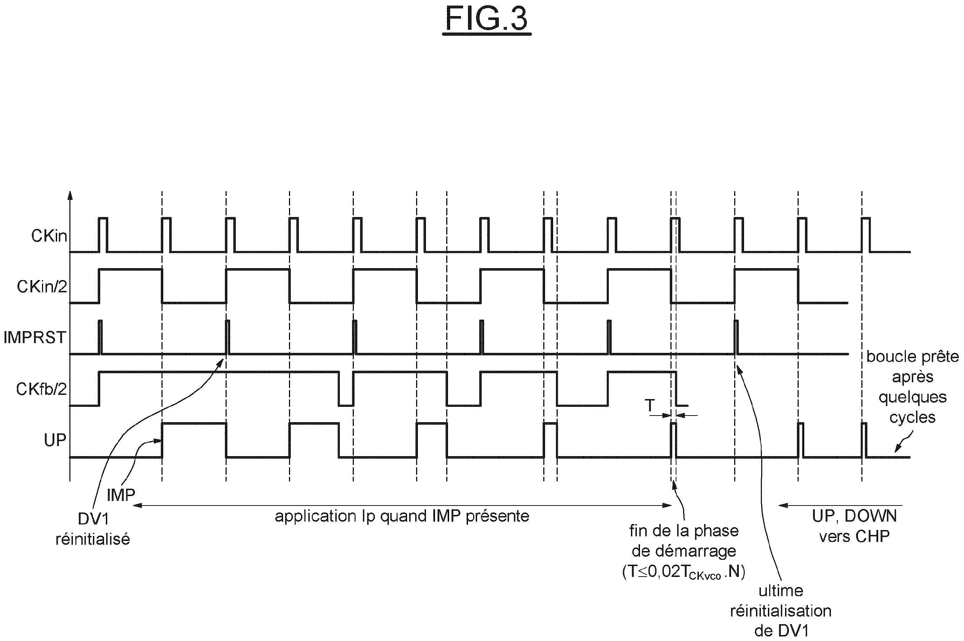

[Fig 3] représentent des modes de mise en œuvre et de réalisation de l'invention.

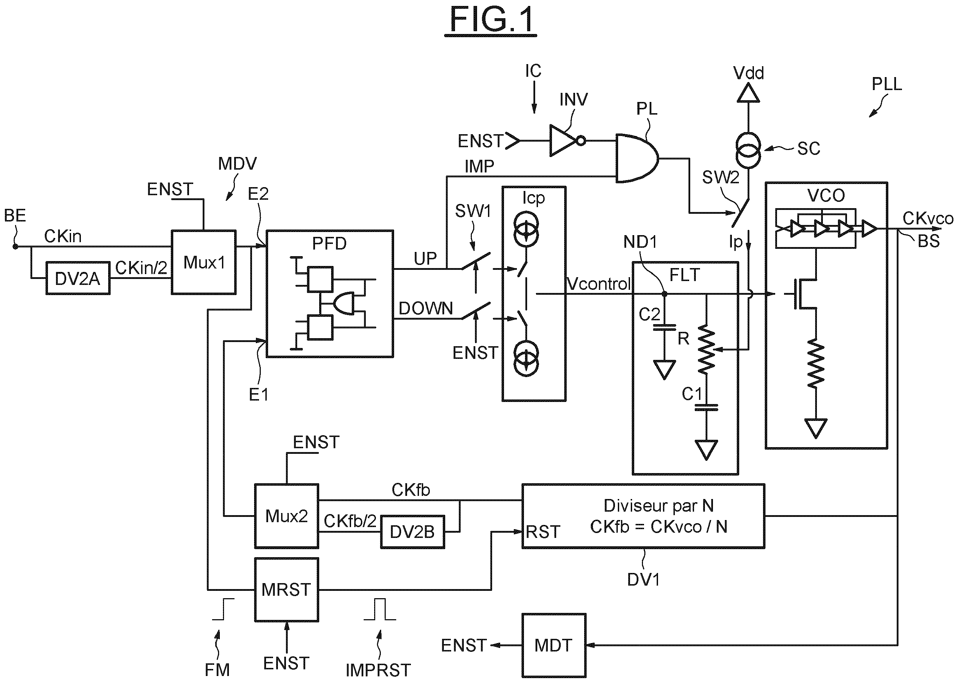

Sur la figure 1, la référence PLL désigne une boucle à verrouillage de phase comportant une entrée BE pour recevoir un signal de référence initial CKin et une borne de sortie BS pour délivrer le signal de sortie CKvco délivré par un oscillateur commandé en tension VCO.

A titre d'exemple, la fréquence du signal de référence initial CKin peut être égale à 16 MHz tandis que la fréquence du signal de sortie CKvco peut être égale à 832 MHz.

Par ailleurs, la borne de sortie BS de la boucle à verrouillage de phase PLL est reliée à l'entrée d'un premier diviseur DV1, par exemple un diviseur fractionnaire, destiné à diviser par N le signal CKvco délivré par l'oscillateur local VCO.

Le rapport de division N est égal au rapport entre la fréquence du signal CKvco et la fréquence du signal de référence initial CKin.

A titre d'exemple, ici, ce rapport de division est égal à 800/16 soit 52. Ce diviseur par N est de structure classique et connue en soi et est formé typiquement par un compteur réinitialisable par réception sur son entrée de réinitialisation RST d'un signal ou impulsion de réinitialisation IMPRST.

Le signal de sortie du premier diviseur est référencé CKfb.

La boucle à verrouillage de phase PLL comporte une phase ou étape de démarrage à l'issue de laquelle le signal de référence délivré en entrée du comparateur de phase PFD (de structure classique et connue) de la boucle et le signal CKfb sont quasiment synchronisés. Bien entendu lorsque le signal de référence et le signal CKfb sont quasiment synchronisés, le signal de référence et le signal de sortie CKvco sont également quasiment synchronisés.

La fin de cette phase de démarrage se produit ici dans cet exemple, lorsqu'un signal logique ENST a par exemple la valeur logique « 1 ».

On suppose maintenant dans cet exemple que le signal de référence initial CKin a un rapport cyclique quelconque, notamment différent de 50%.

La boucle PLL comprend à cet égard des moyens de délivrance MDV configurés pour délivrer sur la deuxième entrée E2 du comparateur de phase PFD, le signal de référence CKin/2 qui est une division par deux du signal de référence initial CKin.

A cet égard, les moyens de délivrance comportent ici par exemple un diviseur par deux, DV2A, qui est en fait un compteur, connecté à la borne d'entrée BE et délivrant le signal de référence CKin/2.

Les moyens de délivrance MDV comportent par ailleurs un premier multiplexeur Mux1, commandé par le signal ENST, recevant d'une part le signal de référence CKin/2 et le signal de référence initial CKin.

Durant la phase de démarrage, c'est-à-dire lorsque le signal logique ENST a la valeur logique « 0 », le multiplexeur Mux1 délivre sur l'entrée E2 le signal de référence initial divisé par deux qui forme de ce fait le signal de référence reçu sur la deuxième entrée E2 du comparateur de phase PFD.

Le signal de retour délivré sur la première entrée E1 du comparateur de phase PFD est issu d'un deuxième multiplexeur Mux2 également commandé par le signal ENST.

Le signal de sortie du premier diviseur CKfb est délivré à une première entrée du deuxième multiplexeur Mux2.

La deuxième entrée du deuxième Mux2 reçoit le signal CKfb/2 délivré par un autre diviseur par deux DV2B et qui résulte par conséquent de la division par deux du signal CKfb.

Ainsi, dans cet exemple, durant la phase de démarrage de la boucle PLL, puisque l'entrée E2 de comparateur de phase reçoit le signal de référence CKin/2, le signal de retour délivré sur la première entrée E1 du comparateur de phase est le signal CKfb/2.

Le comparateur de phase PFD délivre de façon classique, en fonction des signaux présents à ses deux entrées, soit une impulsion de commande UP destinée à augmenter la tension de contrôle ou de commande en entrée de l'oscillateur VCO soit une impulsion de commande DOWN destinée à faire diminuer cette tension de contrôle.

La boucle PLL comporte par ailleurs un filtre résistif capacitif FLT possédant un nœud ND1 connecté à l'entrée de commande ou de contrôle de l'oscillateur contrôlé en tension VCO.

La boucle à verrouillage de phase PLL comporte par ailleurs un circuit de pompe de charge CHP, de structure classique et connue en soi, destinée à recevoir les deux impulsions de commande UP et DOWN, et délivrant un courant au filtre résistif capacitif ce qui produit la tension de contrôle Vcontrol applicable à l'entrée de l'oscillateur.

Cela étant, dans ce mode de réalisation, le comparateur de phase PFD est relié à l'entrée du circuit de pompe de charge CHP par un ensemble de premiers interrupteurs SW1 commandables par le signal logique ENST.

Dans un autre mode de réalisation, l'ensemble de premiers interrupteurs SW1 peut être remplacé par des portes logiques dont une entrée est connectée au signal logique ENST qui permet d'ouvrir les interrupteurs internes au circuit de pompe de charge CHP.

Ainsi, dans ce mode de réalisation, lorsque la boucle à verrouillage de phase est dans sa phase de démarrage (ENST=0, par exemple), les interrupteurs SW1 sont ouverts, déconnectant le circuit de pompe de charge CHP des sorties du comparateur de phase PFD.

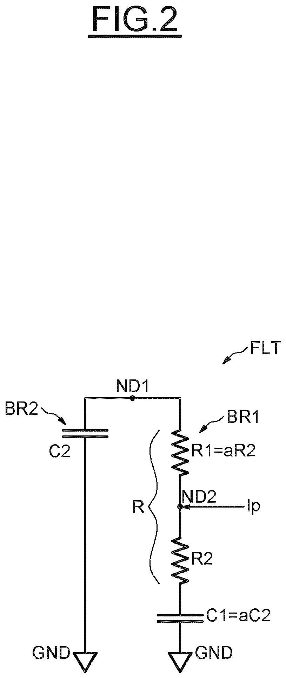

Comme illustré sur la figure 2, le filtre FLT comporte ici une première branche BR1 connectée entre le nœud ND1 et la masse GND et une deuxième branche BR2 également connectée entre le nœud ND1 et la masse GND.

La première branche comprend un réseau résistif R connecté en série avec un premier condensateur C1.

Le réseau résistif R comporte une première résistance R1 connectée entre le nœud ND1 et un nœud intermédiaire ND2 et une deuxième résistance R2 connectée entre le nœud intermédiaire ND2 et le premier condensateur C1.

A des fins de simplification, C1, C2, R1 et R2 désigneront également respectivement la valeur capacitive du premier condensateur C1, la valeur capacitive du deuxième condensateur C2, la valeur résistive de la première résistance R1 et la valeur résistive de la deuxième résistance R2.

Dans cet exemple, la valeur capacitive C1 du premier condensateur C1 est égale à a fois la valeur capacitive C2 du deuxième condensateur C2. A titre indicatif, a est de l'ordre de 10.

La valeur résistive R1 de la première résistance R1 est quant à elle égale à a fois la valeur résistive R2 de la deuxième résistance R2.

De ce fait, le produit R2C1 est égal au produit R1C2 c'est-à-dire à a fois le produit R2C2.

Et, pendant la phase de démarrage, un courant de précharge Ip va être appliqué au nœud intermédiaire ND2.

Et, puisque C1 est égal à aC2, on mettra le même temps pour précharger C1 et C2, ce temps étant égal à la constante du filtre divisée par a.

Comme illustré sur la figure 1, ce courant de précharge Ip est issu d'une source de courant SC activable par l'intermédiaire d'un deuxième interrupteur SW2 commandé par la sortie d'une porte logique ET, référencée PL.

Cette porte PL reçoit sur une première entrée, l'impulsion de commande IMP du signal UP, et sur une deuxième entrée, le signal ENST inversé par un inverseur INV.

Pendant la phase de démarrage, le signal ENST est à « 0 » et il est à « 1 » après la phase de démarrage.

De ce fait pendant la phase de démarrage le deuxième interrupteur SW2 est commandé par les impulsions du signal UP, tandis qu'après la phase de démarrage, le deuxième interrupteur SW2 est toujours ouvert.

Plus précisément, pendant la phase de démarrage, si le signal UP est au niveau haut (représentatif d'une impulsion IMP) l'interrupteur SW2 est fermé et la source de courant délivre le courant de précharge Ip sur le nœud intermédiaire ND2.

Et ceci dure tant que le signal UP est à 1, c'est-à-dire tant que l'impulsion de commande IMP est présente.

Par contre, dès que l'impulsion IMP disparaît (signal UP à zéro) l'interrupteur SW2 est ouvert et aucun courant de précharge n'est délivré au nœud ND2.

Le filtre capacitif FLT se charge donc pendant les impulsions IMP et ces chargements permettent de faire monter la tension de contrôle en entrée de l'oscillateur VCO, ce qui permet par conséquent d'augmenter la fréquence du signal de sortie de cet oscillateur.

La source de courant SC et le filtre FLT font donc partie de moyens de contrôle configurés pour augmenter la tension de contrôle de l'oscillateur au cours de ladite impulsion de commande IMP.

La réinitialisation du premier diviseur DV1 est comme indiqué ci-avant obtenue par l'application d'une impulsion de réinitialisation IMPRST sur l'entrée de réinitialisation RST du diviseur.

Cette impulsion de réinitialisation IMPRST est obtenue, lors de la phase de démarrage, par des moyens de réinitialisation MRST en réponse à chaque front montant FM du signal de référence qui est ici le signal CKin/2.

Bien entendu, il aurait été possible de faire cette réinitialisation sur chaque front descendant du signal CKin/2.

Par ailleurs, comme on le verra plus en détail ci-après, une fois la phase de démarrage terminée, les moyens MRST vont délivrer une ultime impulsion de réinitialisation sur le premier front montant du signal de référence, qui sera cette fois-ci le signal CKin, qui suit la fin de la phase de démarrage.

Les moyens de réinitialisation MRST peuvent être aisément réalisés au moyen de circuits logiques.

Par ailleurs, le circuit intégré IC incorporant la boucle à verrouillage de phase PLL comporte également des moyens de détection MDT configurés pour détecter la fin de la phase de démarrage et délivrer par conséquent la valeur logique 1 au signal ENST.

La fin de la phase de démarrage est considérée comme atteinte lorsque la durée T de l'impulsion de commande IMP correspondant à l'état haut du signal « up » est inférieure à quelques pourcents du produit de la période nominale T_{CKVCO} du signal de sortie de l'oscillateur VCO par le rapport de division N.

A titre d'exemple, ce seuil peut être pris égal à 2%.

Aussi, selon une première possibilité, pour détecter cette condition de fin de phase de démarrage, les moyens de détection MDT peuvent être configurés pour compter le nombre de fronts du signal CKvco pendant la durée de l'impulsion IMP.

Selon un autre mode de réalisation possible, les moyens MDT peuvent comporter un filtre passe-bas recevant le signal UP et dont la constante de temps est reliée audit seuil de quelques pourcents.

Selon que la sortie de ce filtre délivre ou non un signal haut, les moyens MDT délivreront soit la valeur logique « 0 » ou la valeur logique « 1 » du signal ENST.

En variante, la fin de la phase de démarrage peut être également considérée comme atteinte lorsque la première impulsion de commande correspondant à l'état haut du signal « DOWN » est détectée. On se réfère maintenant plus particulièrement à la figure 3 pour illustrer un mode de mise en œuvre du procédé de gestion du fonctionnement de la boucle PLL illustrée sur les figures précédentes.

Cette figure 3 a la forme d'un chronogramme temporel.

Sur la première ligne de cette figure, est représenté le signal de référence initial CKin qui, comme on le voit, a un rapport cyclique différent de 50%.

Sur la deuxième ligne, est représenté le signal de référence CKin/2, résultant de la division par deux du signal de référence initial, et qui cette fois-ci a un rapport cyclique de 50%.

Ce signal CKin/2 est, comme on l'a expliqué ci-avant, le signal de référence délivré sur la deuxième entrée E2 du comparateur de phase PFD.

Par ailleurs, on voit qu'à chaque front montant du signal de référence CKin/2, est émise par les moyens de réalisation MRST, une impulsion de réalisation IMPRST qui réinitialise le premier diviseur DV1, c'est-à-dire qui réinitialise à 0 le compteur formant ce premier diviseur.

Par ailleurs, sur chaque front descendant du signal de référence CKin/2, le comparateur de phase PFD compare la phase du signal de référence CKin/2 avec la phase du signal de retour CKFB/2 et délivre en conséquence l'impulsion de commande IMP du signal UP.

Cette impulsion IMP permet, quand elle est présente, d'appliquer le courant de précharge Ip sur le nœud intermédiaire ND2 du filtre FLT.

On remarque, qu'au fur et à mesure du déroulement de cette phase de démarrage, la durée de l'impulsion IMP du signal UP diminue puisque la fréquence de sortie du signal CKvco augmente.

Et, comme indiqué ci-avant, lorsque la durée T de l'impulsion IMP est inférieure ou égale à 2% du produit du rapport de division N par la période TCKvco du signal d'oscillateur, le signal de commande ENST passe à 1, marquant la fin de la phase de démarrage.

A cet instant, le premier multiplexeur Mux1 délivre, sur la deuxième entrée E2 du comparateur de phase le signal de référence initial CKin qui devient le signal de référence.

Par ailleurs, le signal de retour délivré sur la première entrée E1 du comparateur de phase PFD devient le signal CKfb issu directement du diviseur (c'est-à-dire sans avoir été au préalable divisé par deux).

Dans le même temps, les interrupteurs SW1 sont fermés, connectant les deux sorties (délivrant respectivement les deux signaux UP et DOWN) du comparateur de phase PFD aux entrées du circuit de pompe de charge de façon à retrouver le fonctionnement classique d'une boucle à verrouillage de phase.

L'interrupteur SW2 est ouvert, interrompant l'application du courant de précharge Ip.

Le courant qui permet de réguler la tension de commande Vcontrol de l'oscillateur local VCO est cette fois-ci le courant Icp délivré par le circuit de pompe de charge.

Cela étant, afin d'accélérer la synchronisation du signal CKvco et du signal de référence CKin, les moyens MRST procèdent comme indiqué ci-avant à une ultime réinitialisation du premier diviseur DV1 lors du premier front montant du signal de référence CKin qui suit la fin de la phase de démarrage.

La boucle à verrouillage de phase sera ensuite prête à délivrer son signal de sortie après quelques cycles.

Ce signal de sortie pourra par exemple servir de signal d'horloge à un microprocesseur.

## Revendications

1. Procédé de gestion du fonctionnement d'une boucle à verrouillage de phase (PLL), le fonctionnement de la boucle à verrouillage de phase comprenant une phase de démarrage comportant
- une délivrance à un comparateur de phase (PFD) de la boucle, d'un signal de référence (CKin/2) ayant un rapport cyclique de 50%,
- une réinitialisation, à chaque front d'un premier type du signal de référence, d'un premier diviseur (DV1) du signal de sortie de l'oscillateur contrôlé en tension de la boucle (VCO),
- une délivrance par le comparateur de phase recevant le signal de référence (CKin/2) et un signal de retour (CKfb/2) issu dudit premier diviseur, à chaque front d'un deuxième type du signal de référence, d'une impulsion de commande (IMP) au cours de laquelle la tension de contrôle (Vcontrol) de l'oscillateur augmente.

2. Procédé selon la revendication 1, dans lequel la délivrance dudit signal de référence (CKin/2) comprend une division par deux d'un signal de référence initial (CKin) et ledit signal de retour (CKfb/2) est le signal de sortie (CKfb) du premier diviseur (DV1) divisé par deux.

3. Procédé selon l'une des revendications précédentes, dans lequel au cours de la phase de démarrage, l'augmentation de la tension de contrôle de l'oscillateur comprend une application d'un courant de précharge (Ip) dans un filtre résistif capacitif (FLT) connecté en entrée de l'oscillateur.

4. Procédé selon la revendication 3, dans lequel le filtre résistif capacitif (FLT) comprend
- une première branche (BR1) connectée entre ladite entrée de l'oscillateur et la masse et comportant un réseau résistif connecté en série avec un premier condensateur ayant une première valeur capacitive, ledit réseau résistif comportant une première résistance connectée entre ladite entrée de l'oscillateur et un nœud intermédiaire et ayant une première valeur résistive et une deuxième résistance connectée entre le nœud intermédiaire et le premier condensateur et ayant une deuxième valeur résistive, et
- une deuxième branche (BR2) connectée entre ladite entrée de l'oscillateur et la masse et comportant un deuxième condensateur ayant une deuxième valeur capacitive,
- la première valeur capacitive étant égale à a fois la deuxième valeur capacitive, et la première valeur résistive est égale à a fois la deuxième valeur résistive, et
dans lequel ledit courant de précharge est appliqué audit nœud intermédiaire.

5. Procédé selon l'une des revendications précédentes, dans lequel ladite phase de démarrage se termine lorsque la durée (T) de l'impulsion de commande (IMP) est inférieure à quelques pourcents du produit de la période du signal de sortie de l'oscillateur par le rapport de division du premier diviseur.

6. Procédé selon l'une des revendications précédentes, dans lequel lorsque la phase de démarrage est terminée, la sortie du comparateur de phase (PFD) est connectée à un circuit de pompe de charge (CHP) dont la sortie est connectée à l'entrée de l'oscillateur contrôlé en tension.

7. Procédé selon les revendications 2 et 6, dans lequel lorsque la phase de démarrage est terminée, on délivre au comparateur de phase (PFD) le signal de référence initial (CKin), et le signal de retour délivré au comparateur de phase est le signal de sortie (CKfb) du premier diviseur.

8. Procédé selon la revendication 6 ou 7, comprenant lorsque la phase de démarrage est terminée, une ultime réinitialisation du premier diviseur (DV1) sur le premier front d'un premier type du signal de référence suivant la fin de la phase de démarrage.

9. Circuit intégré, comprenant une boucle à verrouillage de phase (PLL) comportant
- un comparateur de phase (PFD), un oscillateur contrôlé en tension (VCO), un premier diviseur (DV1) connecté entre la sortie de l'oscillateur et une première entrée du comparateur de phase,
- des moyens de délivrance (MDV) configurés pour délivrer sur une deuxième entrée du comparateur de phase, lors d'une phase de démarrage de la boucle, un signal de référence ayant un rapport cyclique de 50%,
- des moyens de réinitialisation (MRST) configurés pour, lors de ladite phase de démarrage, effectuer à chaque front d'un premier type du signal de référence, une réinitialisation du premier diviseur,
- le comparateur de phase étant configuré pour, lors de ladite phase de démarrage, délivrer, à chaque front d'un deuxième type du signal de référence, une impulsion de commande, et
- des moyens de contrôle (SC, FLT) configurés pour augmenter la tension de contrôle de l'oscillateur au cours de ladite impulsion.

10. Circuit intégré selon la revendication 9, dans lequel les moyens de délivrance (MDV) comportent une entrée pour recevoir un signal de référence initial, un diviseur par deux connecté à ladite entrée, et une sortie configurée pour délivrer en tant que signal de référence, le signal de référence initial divisé par deux et le circuit intégré comprend en outre un autre diviseur par deux connecté entre la sortie du premier diviseur et la première entrée du comparateur de phase.

11. Circuit intégré selon l'une des revendications 9 ou 10, dans lequel les moyens de contrôle comportent une source de courant (SC) activable lors de ladite impulsion et configurée pour appliquer, une fois activée, un courant de précharge dans un filtre résistif capacitif (FLT) connecté en entrée de l'oscillateur.

12. Circuit intégré selon la revendication 11, dans lequel le filtre résistif capacitif (FLT) comprend
- une première branche (BR1) connectée entre ladite entrée de l'oscillateur et la masse et comportant un réseau résistif connecté en série avec un premier condensateur ayant une première valeur capacitive, ledit réseau résistif comportant une première résistance connectée entre ladite entrée de l'oscillateur et un nœud intermédiaire et ayant une première valeur résistive et une deuxième résistance connectée entre le nœud intermédiaire et le premier condensateur et ayant une deuxième valeur résistive, et
- une deuxième branche (BR2) connectée entre ladite entrée de l'oscillateur et la masse et comportant un deuxième condensateur ayant une deuxième valeur capacitive,
- la première valeur capacitive étant égale à a fois la deuxième valeur capacitive, et la première valeur résistive est égale à a fois la deuxième valeur résistive, et
dans lequel la source de courant est connectée audit nœud intermédiaire.

13. Circuit intégré selon l'une des revendications 9 à 12, comprenant en outre des moyens de détection (MDT) configurés pour détecter la fin de la phase de démarrage.

14. Circuit intégré selon la revendication 13, dans lequel les moyens de détection (MDT) sont configurés pour détecter la durée (T) de l'impulsion de commande (IMP) et/ou la nature du signal impulsionnel délivré par le comparateur de phase.

15. Circuit intégré selon la revendication 14, dans lequel les moyens de détection sont configurés pour délivrer un signal représentatif de la fin de la phase de démarrage lorsque la durée de l'impulsion de commande est inférieure à quelques pourcents du produit de la période du signal de sortie de l'oscillateur par le rapport de division du premier diviseur.

16. Circuit intégré selon l'une des revendications 9 à 15, configuré pour, lorsque la phase de démarrage est terminée, connecter la sortie du comparateur de phase (PFD) à un circuit de pompe de charge (CHP) dont la sortie est connectée à l'entrée de l'oscillateur contrôlé en tension.

17. Circuit intégré selon les revendications 10 et 16, dans lequel, lorsque la phase de démarrage est terminée, les moyens de délivrance (MDV) sont configurés pour délivrer au comparateur de phase le signal de référence initial, et le circuit intégré comporte des moyens de commande configurés pour désactiver ledit autre diviseur par deux, de façon que le signal de retour délivré au comparateur de phase soit le signal de sortie du premier diviseur.

18. Circuit intégré selon la revendication 16 ou 17, dans lequel les moyens de réinitialisation (MRST) sont configurés pour, lorsque la phase de démarrage est terminée, effectuer une ultime réinitialisation du premier diviseur sur le premier front d'un premier type du signal de référence suivant la fin de la phase de démarrage.

## Patentansprüche

1. Verfahren zur Steuerung des Betriebs einer Phasenregelschleife (PLL), wobei der Betrieb der Phasenregelschleife eine Startphase umfasst, die aufweist
- eine Ausgabe eines Referenzsignals (CKin/2) mit einem zyklischen Verhältnis von 50 % an einen Phasenkomparator (PFD) der Schleife,
- eine Reinitialisierung an jeder Front eines ersten Typs des Referenzsignals eines ersten Teilers (DV1) des Ausgangssignals des spannungsgesteuerten Oszillators der Schleife (VCO),
- eine Ausgabe an jeder Front eines zweiten Typs des Referenzsignals eines Steuerimpulses (IMP), bei dem die Steuerspannung (Vcontrol) des Oszillators steigt, durch den Phasenkomparator, der das Referenzsignal (CKin/2) und ein vom ersten Teiler ausgehendes Rückkopplungssignal (CKfb/2) empfängt.

2. Verfahren nach Anspruch 1, wobei die Ausgabe des Referenzsignals (CKin/2) eine Teilung durch zwei eines Basisreferenzsignals (CKin) umfasst und das Rückkopplungssignal (CKfb/2) das Ausgangssignal (CKfb) des ersten Teilers (DV1) geteilt durch zwei ist.

3. Verfahren nach einem der vorangehenden Ansprüche, wobei während der Startphase die Erhöhung der Steuerspannung des Oszillators eine Anwendung eines Vorladestroms (Ip) in einem resistiv-kapazitiven Filter (FLT) umfasst, der am Eingang des Oszillators angeschlossen ist.

4. Verfahren nach Anspruch 3, wobei der resistiv-kapazitive Filter (FLT) umfasst
- eine erste Abzweigung (BR1), die zwischen dem Eingang des Oszillators und der Masse geschaltet ist und ein resistives Netzwerk aufweist, das in Reihe mit einem ersten Kondensator geschaltet ist, der einen ersten kapazitiven Wert hat, wobei das resistive Netzwerk einen ersten Widerstand aufweist, der zwischen dem Eingang des Oszillators und einem Vermittlungsknoten geschaltet ist und einen ersten resistiven Wert hat und einen zweiten Widerstand, der zwischen dem Vermittlungsknoten und dem ersten Kondensator geschaltet ist und einen zweiten resistiven Wert hat, und
- eine zweite Abzweigung (BR2), die zwischen dem Eingang des Oszillators und der Masse geschaltet ist und einen zweiten Kondensator aufweist, der einen zweiten kapazitiven Wert hat,
- wobei der erste kapazitive Wert gleich a Mal dem zweiten kapazitiven Wert ist und der erste resistive Wert gleich a Mal dem zweiten resistiven Wert ist, und
wobei der Vorladestroms am Vermittlungsknoten angewendet wird.

5. Verfahren nach einem der vorangehenden Ansprüche, wobei die Startphase endet, wenn die Dauer (T) des Steuerimpulses (IMP) kleiner als einige Prozent des Produkts der Periode des Ausgangssignals des Oszillators durch den Teilungsquotienten des ersten Teilers ist.

6. Verfahren nach einem der vorangehenden Ansprüche, wobei, wenn die Startphase beendet ist, der Ausgang des Phasenkomparators (PFD) mit einer Ladungspumpschaltung (CHP) verbunden ist, deren Ausgang mit dem Eingang des spannungsgesteuerten Oszillators verbunden ist.

7. Verfahren nach den Ansprüchen 2 und 6, wobei, wenn die Startphase beendet ist, an den Phasenkomparator (PFD) das Basisreferenzsignal (CKin) ausgegeben wird und das dem Phasenkomparator ausgegebene Rückkopplungssignal das Ausgangssignal (CKfb) des ersten Teilers ist.

8. Verfahren nach Anspruch 6 oder 7, das, wenn die Startphase beendet ist, eine allerletzte Reinitialisierung des ersten Teilers (DV1) auf der ersten Front eines ersten Typs des Referenzsignals nach dem Ende der Startphase umfasst.

9. Integrierter Schaltkreis, der eine Phasenregelschleife (PLL) umfasst, aufweisend
- einen Phasenkomparator (PFD), einen spannungsgesteuerten Oszillator (VCO), einen ersten Teiler (DV1), der zwischen dem Ausgang des Oszillators und einem ersten Eingang des Phasenkomparators geschaltet ist,
- Ausgabemittel (MDV), die ausgelegt sind, um über einen zweiten Eingang des Phasenkomparators bei einer Startphase der Schleife ein Referenzsignal mit einem zyklischen Verhältnis von 50 % auszugeben,
- Reinitialisierungsmittel (MRST), die ausgelegt sind, um bei der Startphase an jeder Front eines ersten Typs des Referenzsignals eine Reinitialisierung des ersten Teilers durchzuführen,
- wobei der Phasenkomparator ausgelegt ist, um bei der Startphase an jeder Front eines zweiten Typs des Referenzsignals einen Steuerimpuls auszugeben, und
- Steuermittel (SC, FLT), die ausgelegt sind, um die Steuerspannung des Oszillators während des Impulses zu erhöhen.

10. Integrierter Schaltkreis nach Anspruch 9, wobei die Ausgabemittel (MDV) einen Eingang aufweisen, um ein Basisreferenzsignal zu empfangen, einen mit dem Eingang verbundenen 2-Teiler und einen Ausgang, der ausgelegt ist, um als Referenzsignal das Basisreferenzsignal geteilt durch zwei bereitzustellen und der integrierte Schaltkreis ferner einen anderen 2-Teiler umfasst, der zwischen dem Ausgang des ersten Teilers und dem ersten Eingang des Phasenkomparators geschaltet ist.

11. Integrierter Schaltkreis nach einem der Ansprüche 9 oder 10, wobei die Steuermittel eine Stromquelle (SC) aufweisen, die bei dem Impuls aktivierbar und ausgelegt ist, um, nachdem sie aktiviert wurde, einen Vorladestrom in einem resistiv-kapazitiven Filter (FLT) anzuwenden, der am Eingang des Oszillators geschaltet ist.

12. Integrierter Schaltkreis nach Anspruch 11, wobei der resistiv-kapazitive Filter (FLT) umfasst
- eine erste Abzweigung (BR1), die zwischen dem Eingang des Oszillators und der Masse geschaltet ist und ein resistives Netzwerk aufweist, das in Reihe mit einem ersten Kondensator geschaltet ist, der einen ersten kapazitiven Wert hat, wobei das resistive Netzwerk einen ersten Widerstand aufweist, der zwischen dem Eingang des Oszillators und einem Vermittlungsknoten geschaltet ist und einen ersten resistiven Wert hat und einen zweiten Widerstand, der zwischen dem Vermittlungsknoten und dem ersten Kondensator geschaltet ist und einen zweiten resistiven Wert hat, und
- eine zweite Abzweigung (BR2), die zwischen dem Eingang des Oszillators und der Masse geschaltet ist und einen zweiten Kondensator aufweist, der einen zweiten kapazitiven Wert hat,
- wobei der erste kapazitive Wert gleich a Mal dem zweiten kapazitiven Wert ist und der erste resistive Wert gleich a Mal dem zweiten resistiven Wert ist, und
wobei der Vorladestroms am Vermittlungsknoten anliegt.

13. Integrierter Schaltkreis nach einem der Ansprüche 9 bis 12, der ferner Detektionsmittel (MDT) umfasst, die ausgelegt sind, um das Ende der Startphase zu ermitteln.

14. Integrierter Schaltkreis nach Anspruch 13, wobei die Detektionsmittel (MDT) ausgelegt sind, um die Dauer (T) des Steuerimpulses (IMP) und/oder die Art des vom Phasenkomparator bereitgestellten Impulssignals zu ermitteln.

15. Integrierter Schaltkreis nach Anspruch 14, wobei die Detektionsmittel ausgelegt sind, um ein für das Ende der Startphase repräsentatives Signal bereitzustellen, wenn die Dauer des Steuerimpulses kleiner als einige Prozent des Produkts der Periode des Ausgangssignals des Oszillators durch den Teilungsquotienten des ersten Teilers ist.

16. Integrierter Schaltkreis nach einem der Ansprüche 9 bis 15, der ausgelegt ist, um, wenn die Startphase beendet ist, den Ausgang des Phasenkomparators (PFD) mit einer Ladungspumpschaltung (CHP) zu verbinden, deren Ausgang mit dem Eingang des spannungsgesteuerten Oszillators verbunden ist.

17. Integrierter Schaltkreis nach den Ansprüchen 10 und 16, wobei, wenn die Startphase beendet ist, die Ausgabemittel (MDV) ausgelegt sind, um dem Phasenkomparator das Basisreferenzsignal bereitzustellen und der integrierte Schaltkreis Steuermittel aufweist, die ausgelegt sind, um den anderen 2-Teiler zu deaktivieren, so dass das Rückkopplungssignal, das dem Phasenkomparator bereitgestellt wird, das Ausgangssignal des ersten Teilers ist.

18. Integrierter Schaltkreis nach Anspruch 16 oder 17, wobei die Reinitialisierungsmittel (MRST) ausgelegt sind, um, wenn die Startphase beendet ist, eine allerletzte Reinitialisierung des ersten Teilers auf der ersten Front eines ersten Typs des Referenzsignals nach dem Ende der Startphase durchzuführen.

## Claims

1. A method for managing the operation of a phase-locked loop (PLL), the operation of the phase-locked loop comprising a start phase including
- delivering to a phase comparator (PFD) of the loop, a reference signal (CKin/2) having a duty ratio of 50%,
- resetting, at each edge of a first type of the reference signal, a first divider (DV1) of the output signal of the voltage-controlled oscillator (VCO) of the loop,
- delivering by the phase comparator receiving the reference signal (CKin/2) and a return signal (CKfb/2) from said first divider, at each edge of a second type of the reference signal, a drive pulse (IMP) during which the control voltage (Vcontrol) of the oscillator increases.

2. The method according to claim 1, wherein delivering said reference signal (CKin/2) comprises dividing by two an initial reference signal (CKin), and said return signal (CKfb/2) is the output signal (CKfb) of the first divider (DV1) divided by two.

3. The method according to one of the preceding claims, wherein during the start phase, increasing the control voltage of the oscillator comprises applying a precharge current (Ip) in a capacitive resistive filter (FLT) connected as to input to the oscillator.

4. The method according to claim 3, wherein the capacitive resistive filter (FLT) comprises
- a first branch (BR1) connected between said input of the oscillator and the ground and including a resistive network connected in series with a first capacitor having a first capacitive value, said resistive network including a first resistor connected between said input of the oscillator and an intermediate node and having a first resistive value and a second resistor connected between the intermediate node and the first capacitor and having a second resistive value, and
- a second branch (BR2) connected between said input of the oscillator and the ground and including a second capacitor having a second capacitive value,
- the first capacitive value being equal to a times the second capacitive value, and the first resistive value is equal to a times the second resistive value, and
wherein said precharge current is applied to said intermediate node.

5. The method according to one of the preceding claims, wherein said start phase ends when the duration (T) of the drive pulse (IMP) is less than a few percents of the product of the period of the output signal of the oscillator by the division ratio of the first divider.

6. The method according to one of the preceding claims, wherein when the start phase is ended, the output of the phase comparator (PFD) is connected to a charge pump circuit (CHP) the output of which is connected to the input of the voltage-controlled oscillator.

7. The method according to claims 2 and 6, wherein when the start phase is ended, the initial reference signal (CKin) is delivered to the phase comparator (PFD), and the return signal delivered to the phase comparator is the output signal (CKfb) of the first divider.

8. The method according to claim 6 or 7, comprising when the start phase is ended, a final reset of the first divider (DV1) on the first edge of a first type of the reference signal following the end of the start phase.

9. An integrated circuit, comprising a phase-locked loop (PLL) including
- a phase comparator (PFD), a voltage-controlled oscillator (VCO), a first divider (DV1) connected between the output of the oscillator and a first input of the phase comparator,
- delivery means (MDV) configured to deliver to a second input of the phase comparator, during a start phase of the loop, a reference signal having a duty ratio of 50%,
- reset means (MRST) configured to, during said start phase, perform at each edge of a first type of the reference signal, reset of the first divider,
- the phase comparator being configured to, during said start phase, deliver, each edge of a second type of the reference signal, a drive pulse, and
- control means (SC, FLT) configured to increase the control voltage of the oscillator during said pulse.

10. The integrated circuit according to claim 9, wherein the delivery means (MDV) include an input to receive an initial reference signal, a divider by two connected to said input, and an output configured to deliver as a reference signal, the initial reference signal divided by two and the integrated circuit further comprises another divider by two connected between the output of the first divider and the first input of the phase comparator.

11. The integrated circuit according to one of claims 9 or 10, wherein the control means include a current source (SC) activatable during said pulse and configured to apply, once activated, a precharge current in a capacitive resistive filter (FLT) connected as an input to the oscillator.

12. The integrated circuit according to claim 11, wherein the capacitive resistive filter (FLT) comprises
- a first branch (BR1) connected between said input of the oscillator and ground and including a resistive network connected in series with a first capacitor having a first capacitive value, said resistive network including a first resistor connected between said input of the oscillator and an intermediate node and having a first resistive value and a second resistor connected between the intermediate node and the first capacitor and having a second resistive value, and
- a second branch (BR2) connected between said input of the oscillator and the ground and including a second capacitor having a second capacitive value,
- the first capacitive value being equal to a times the second capacitive value, and the first resistive value is equal to a times the second resistive value, and
wherein the current source is connected to said intermediate node.

13. The integrated circuit according to one of claims 9 to 12, further comprising detection means (MDT) configured to detect the end of the start phase.

14. The integrated circuit according to claim 13, wherein the detection means (MDT) are configured to detect the duration (T) of the drive pulse (IMP) and/or the nature of the pulse signal delivered by the phase comparator.

15. The integrated circuit according to claim 14, wherein the detection means are configured to deliver a signal representative of the end of the start phase when the duration of the drive pulse is less than a few percents of the product of the period of the output signal of the oscillator by the division ratio of the first divider.

16. The integrated circuit according to one of claims 9 to 15, configured to, when the start phase is ended, connect the output of the phase comparator (PFD) to a charge pump circuit (CHP) the output of which is connected to the input of the voltage-controlled oscillator.

17. The integrated circuit according to claims 10 and 16, wherein, when the start phase is ended, the delivery means (MDV) are configured to deliver to the phase comparator the initial reference signal, and the integrated circuit includes drive means configured to deactivate said other divider by two, so that the return signal delivered to the phase comparator is the output signal of the first divider.

18. The integrated circuit according to claim 16 or 17, wherein the reset means (MRST) are configured to, when the start phase is ended, perform a final reset of the first divider on the first edge of a first type of the reference signal following the end of the start phase.
